(19) Europäisches Patentamt
European Patent Office
Office européen des brevets

(11) EP 2 551 323 A1

(12) **EUROPEAN PATENT APPLICATION**
published in accordance with Art. 153(4) EPC

(43) Date of publication:
**30.01.2013 Bulletin 2013/05**

(21) Application number: **11759312.9**

(22) Date of filing: **17.03.2011**

(51) Int Cl.:
***C09J 201/00*** *(2006.01)* ***C09J 7/02*** *(2006.01)*
***C09J 11/06*** *(2006.01)*

(86) International application number:
**PCT/JP2011/056460**

(87) International publication number:
**WO 2011/118506 (29.09.2011 Gazette 2011/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.03.2010 JP 2010068793**

(71) Applicant: **Sekisui Chemical Co., Ltd.**
**Osaka-shi, Osaka 530-8565 (JP)**

(72) Inventors:
- **NOMURA Shigeru**
  **Mishima-gun**
  **Osaka 618-0021 (JP)**
- **SUGITA Daihei**
  **Mishima-gun**
  **Osaka 618-0021 (JP)**
- **TONEGAWA Toru**
  **Mishima-gun**
  **Osaka 618-0021 (JP)**

(74) Representative: **Hart-Davis, Jason et al**
**Cabinet Beau de Loménie**
**158, rue de l'Université**
**75340 Paris Cedex 07 (FR)**

(54) **ADHESIVE COMPOSITION, ADHESIVE TAPE, METHOD FOR PROCESSING SEMICONDUCTOR WAFER AND METHOD FOR PRODUCING TSV WAFER**

(57) The present invention aims to provide an adhesive composition having high adhesive strength, as well as being easily detachable and having excellent heat resistance, an adhesive tape comprising the adhesive composition, a method for treating a semiconductor wafer using the adhesive tape, and a method for producing a TSV wafer. The present invention relates to an adhesive composition comprising: an adhesive component; and a tetrazole compound represented by the following formula (1), formula (2), or formula (3), or its salt:

[Chem. 1]

EP 2 551 323 A1

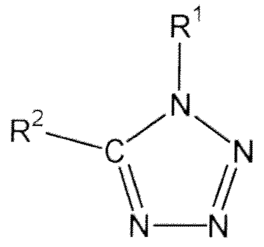

(1)

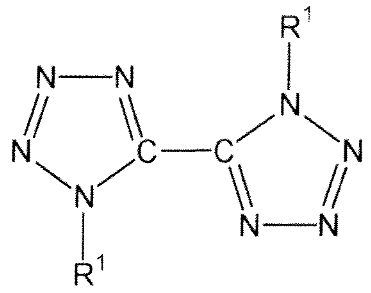

(2)

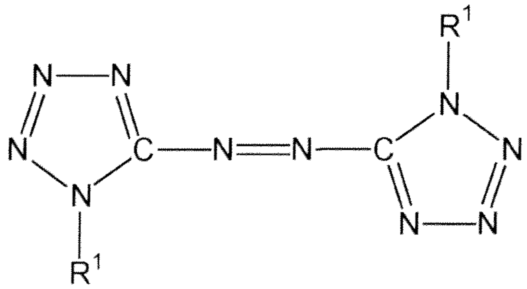

(3)

wherein $R^1$ and $R^2$ each may be hydrogen, a hydroxy group, an amino group, or a C1-C7 alkyl group, alkylene group, phenyl group, or mercapto group; and the C1-C7 alkyl group, alkylene group, phenyl group, and mercapto group may be substituted.

**Description**

TECHNICAL FIELD

The present invention relates to an adhesive composition having high adhesive strength as well as being easily detachable and having excellent heat resistance, an adhesives tape comprising the adhesive composition, a method for treating a semiconductor wafer using the adhesive tape, and a method for producing a TSV wafer.

BACKGROUND ART

Adhesive compositions containing adhesive components are widely used in various applications such as binder agents including adhesives, sealants, paints, and coating agents, and pressure-sensitive agents including pressure-sensitive tapes and self-supporting tapes.
These adhesive compositions are required to have various properties depending on their uses. In certain uses, they may be required to show adhesiveness only for a desired period and thereafter to be easily detachable.
In steps such as grinding of a thick wafer cut out from a high-purity silicon mono crystal into a thin wafer with a predetermined thickness in production of semiconductor chips, for example, it is proposed to attach a thick wafer to a supporting plate to reinforce the wafer, thereby achieving efficient working procedure. Also, in the step of dicing a thin wafer, which has a predetermined thickness and is grind-prepared from a thick wafer, into semiconductor chips, a pressure-sensitive tape called a dicing tape is used. Adhesive compositions used in such semiconductor production are required to adhere firmly to adherends during the process, whereas required to be detached from the obtained products such as thin wafers and semiconductor chips after the process without damages on the products such as thin wafer and semiconductor chips (hereinafter, such characteristics are also referred to as "high adhesion and easy detachment").
Three-dimensional integration technology using TSV (through Si via) is focused on as next-generation technology; in the technology, multiple semiconductor chips are integrated so that the performance of a device is extremely improved and the device is downsized. The TSV enables high-density semiconductor packaging, dramatically increases an access speed, and is excellent in discharging heat generated when the device is used.
Production of such TSVs requires high-temperature treatment processes at 200°C or higher, such as bumping of thin wafers prepared by grinding, backside bumping, and reflow during three-dimensional integration. Therefore, adhesive compositions used in the TSV production is required to have heat resistance to the extent that the compositions can maintain adhesiveness even at a temperature as high as about 250°C, in addition to high adhesion and easy detachment.
Patent Literature 1 discloses, as an adhesive composition achieving high adhesion and detachment, a pressure-sensitive tape comprising a photo-curable pressure-sensitive agent which is cured by light (e.g. ultraviolet rays) application to cause reduction in its viscosity. Such a pressure-sensitive tape can securely hold a semiconductor during processing and can be easily detached by light (e.g. ultraviolet rays) application. The viscosity of the pressure-sensitive tape disclosed in Patent Literature 1 is insufficiently decreased after light (e.g. ultraviolet rays) application, however, and it is difficult to detach the tape without damages on the products such as thin wafers or semiconductor chips.
Patent Literature 2 discloses a heat-detachable pressure-sensitive sheet comprising a pressure-sensitive layer that contains heat-expandable microspheres. When the heat-detachable pressure-sensitive sheet of Patent Literature 2 is heated to not lower than a certain temperature, the heat-expandable microspheres expand and the whole pressure-sensitive layer is foamed. Thereby, convex and concave portions are formed on the surface and the area of the portions attached to an adherend is reduced. As a result, the adherend is easily detached therefrom. In the heat-detachable pressure-sensitive sheet of Patent Literature 2, however, the heat-expandable microspheres expand by heat, and fine convex and concave portions occur on the surface of the pressure-sensitive agent. Such a change in shape of the pressure-sensitive layer adhered to the adherend face-to-face during the sphere expansion generates a stress for detaching the pressure-sensitive layer from the adherend, and thus the detachment proceeds. In contrast, the fine convex and concave portions still adhere to the adherend point-to-point so that the adhesive force remains. Therefore, it is difficult to detach the sheet from the products such as thin wafers and semiconductor chips without damages thereon. Further, the adhesive problematically remains on the surface of the detached adherend. Even in the case of heat-expandable microspheres with relatively high heat resistance, they can be impervious to temperatures as high as about 130°C, and thus it is difficult to use these microspheres in TSV production.
Patent Literature 3 discloses a double-sided pressure-sensitive tape having a pressure-sensitive layer that contains a gas-generating agent which generates a gas by stimulus, such as azo compounds. A stimulus to the double-sided pressure-sensitive tape of Patent Literature 3 causes release of a gas generated from the gas generating agent to the interface between the tape surface and an adherend, and the pressure of the release causes at least partial detachment of the adherend. The double-sided pressure-sensitive tape of Patent Literature 3 enables to detach the products such as thin wafers or semiconductor chips without damages and adhesive remaining. Disadvantageously, even the double-sided pressure-sensitive tape of Patent Literature 3 has a problem in heat resistance, and it is difficult

to use this tape in TSV production.

In current TSV production, adhesion is performed using a pressure-sensitive adhesive containing fine powder of a light-absorbing material such as carbon black, and decomposition and detachment of the pressure-sensitive adhesive are performed utilizing laser-induced heat (Non Patent Literature 1). Disadvantageously, the technique of Non Patent Literature 1 is accompanied by problems such as an equipment problem that a laser irradiation device is needed, and a condition problem that the fine powder is dispersed due to decomposition of the pressure-sensitive agent by laser irradiation, and thereby the cleanness of the production environment deteriorates.

CITATION LIST

- Patent Literature

Patent Literature 1: Japanese Kokai Publication No. Hei-05-32946 (JP-A H05-32946)
Patent Literature 2: Japanese Kokai Publication No. Hei-11-166164 (JP-A H11-166164.)
Patent Literature 3: Japanese Kokai Publication No. 2003-231872 (JP-A 2003-231872)

- Non Patent Literature

Non Patent Literature 1: "Secchaku no gijutsu", Vol. 28, No. 1 (2008), the 90th volume of the set, P. 28

SUMMARY OF INVENTION

- Technical Problem

The present invention aims to provide an adhesive composition having high adhesive strength as well as being easily detachable and having excellent heat resistance, an adhesive tape comprising the adhesive composition, a method for treating a semiconductor wafer using the adhesive tape, and a method for producing a TSV wafer.

- Solution to Problem

The present invention relates to an adhesive composition comprising an adhesive component and a tetrazole compound represented by the formula (1), the formula (2), or the formula (3), or its salt :

[Chem. 1]

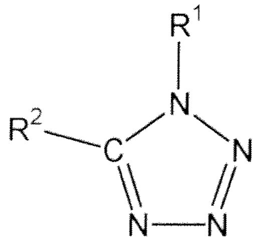

(1)

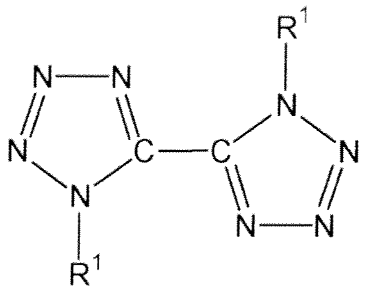

(2)

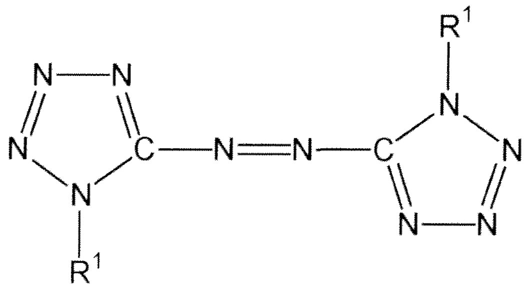

(3)

in the formulas (1) to (3), $R^1$ and $R^2$ each represent hydrogen, a hydroxy group, an amino group, or a C1-C7 alkyl group, alkylene group, phenyl group, or mercapto group; and the C1-C7 alkyl group, alkylene group, phenyl group, and mercapto group may be optionally substituted.
The present invention will be described in detail below.

The present investors have found that the tetrazole compounds represented by the formulas (1) to (3) or their salts generate a gas (nitrogen gas) by light application, whereas they have high heat resistance that they are not decomposed at high temperatures as high as about 200°C. Then, the present inventors have further found that an adhesive composition comprising these compounds and an adhesive component together has high adhesive strength and is easily detached, and that the composition is furthermore excellent in heat resistance to the extent that it can be used in TSV production, and thereby completed the present invention.

The adhesive composition of the present invention contains an adhesive component.
The adhesive component is not particularly limited, and may contain either of a non-curable adhesive or a curable adhesive.
If the adhesive component contains a non-curable adhesive, the adhesive composition of the present invention is detached by light application in a mechanism disclosed in Patent Literature 2. In other words, light application generates a gas from the tetrazole compound represented by one of the formulas (1) to (3) or its salt, and the generated gas causes foaming of the whole of a soft adhesive component. Thereby, convex and concave portions are formed on the surface

so that a detaching stress occurs, and the adhering area with the adherend is reduced, whereby the composition is detached.

If the adhesive component contains a curable adhesive, the adhesive composition of the present invention is detached by light application in a mechanism disclosed in Patent Literature 3. In other words, light application generates a gas from the tetrazole compound represented by one of the formulas (1) to (3) or its salt. The generated gas is released from the cured adhesive to the interface with the adherend, and the pressure upon the release causes at least partial detachment of the adherend.

In particular, the adhesive component preferably contains a curable adhesive whose elastic modulus increases by stimulus because such an adhesive enables secure detachment without adhesive remaining.

The non-curable adhesive is not particularly limited. Examples thereof include rubbery adhesives, acrylic adhesives, vinyl alkyl ether adhesives, silicone adhesives, polyester adhesives, polyamide adhesives, urethane adhesives, and styrene-diene block copolymer adhesives.

The curable adhesive is not particularly limited. Examples thereof include light-curable adhesives and heat-curable adhesives which contain a polymerizable polymer as a main component and a photo polymerization initiator or a heat polymerization initiator.

Such light-curable adhesives and heat-curable adhesives are uniformly and rapidly polymerized and crosslinked as a whole to be integrated by light irradiation or heating, so that the elastic modulus extremely increases by polymerization curing and the adhesive force greatly decreases. Further, when a gas is generated from the tetrazole compound represented by one of the formulas (1) to (3) or its salt in a hard cured product with an increased elastic modulus, most part of the generated gas is released outside and the released gas detaches at least a part of the adhesion face of the pressure-sensitive agent from the adherend to cause a reduced force.

For example, the polymerizable polymer is obtainable by previously synthesizing a (meth) acrylic polymer having a functional group in its molecule (hereinafter, referred to as a functional group-containing (meth) acrylic polymer) and then reacting this polymer with a compound that has a functional group reactive with the above functional group and a radical polymerizable unsaturated bond in its molecule (hereinafter, referred to as a functional group-containing unsaturated compound).

The functional group-containing (meth)acryilc polymer is obtainable as a polymer having pressure-sensitiveness at normal temperature, in the same manner as in the case of common (meth)acrylic polymers, by preparing as a main monomer an alkyl acrylate and/or an alkyl methacrylate whose alkyl group generally has 2 to 18 carbon atoms; and copolymerizing the main monomer, a functional group-containing monomer, and if necessary a third monomer for modification copolymerizable with the above monomers by a common method. The weight average molecular weight of the functional group-containing (meth)acrylic polymer is commonly about 200,000 to 2,000,000.

Examples of the functional group-containing monomer include carboxyl group-containing monomers such as acrylic acid and methacrylic acid; hydroxyl group-containing monomers such as hydroxyethyl acrylate and hydroxyethyl methacrylate; epoxy group-containing monomers such as glycidyl acrylate and glycidyl methacrylate; isocyanato group-containing such as isocyanatoethyl acrylate and isocyanatoethyl methacrylate; and amino group-containing monomers such as aminoethyl acrylate and aminoethyl methacrylate.

Examples of the third copolymerizable monomer for modification include various monomers used for common (meth)acrylic polymers such as vinyl acetate, acrylonitrile, and styrene.

The functional group-containing unsaturated compound to be reacted with the functional group-containing (meth) acrylic polymer may be the same as the aforementioned functional group-containing monomer depending on the functional group of the functional group-containing (meth) acrylic polymer. If the functional group of the functional group-containing (meth) acrylic polymer is a carboxyl group, an epoxy group-containing monomer or an isocyanato group-containing monomer may be used. If the functional group is a hydroxyl group, an isocyanato group-containing monomer may be used. If the functional group is an epoxy group, a carboxyl group-containing monomer or an amide group-containing monomer such as acrylamide may be used. If the functional group is an amino group, an epoxy group-containing monomer may be used.

Examples of the photo polymerization initiator include those activated by application of light with a wavelength of 250 to 800 nm. Specific examples of such a photo polymerization initiator include photo radical polymerization initiators such as acetophenone derivative compounds (e.g. methoxyacetophenone); benzoin ether compounds (e.g. benzoin propyl ether and benzoin isobutyl ether); ketal derivative compounds (e.g. benzil dimethyl ketal and acetophenone diethyl ketal) ; phosphine oxide derivative compounds; bis ($\eta$-5-cyclopentadienyl) titanocene derivative compounds; as well as benzophenone, Michler's ketone, chlorothioxanthone, dodecylthioxanthone, dimethylthioxanthone, diethylthioxanthone, $\alpha$-hydroxycyclohexylphenylketone, and 2-hydroxymethylphenylpropane. Each of these photo polymerization initiators may be used alone, or two or more of these may be used in combination.

Examples of the heat polymerization initiator include those pyrolizable to generate active radicals that initiate polymerization curing. Specific examples thereof include dicumyl peroxide, di-t-butyl peroxide, t-butyl peroxybenzoate, t-butyl hydroperoxide, benzoyl peroxide, cumene hydroperoxide, diisopropylbenzene hydroperoxide, paramenthane

hydroperoxide, and di-t-butylperoxide.
In order that the adhesive composition of the present invention can exert high heat resistance, the heat polymerization initiator preferably has a pyrolysis temperature, of 200°C or higher. Examples of heat polymerization initiators with such a high pyrolysis temperature include cumene hydroperoxide, paramenthane hydroperoxide, and di-t-butyl peroxide.
Commercially available ones of these heat polymerization initiators are not particularly limited. Suitable examples thereof include PERBUTYL D, PERBUTYL H, PERBUTYL P, and PERPENTA H (all marketed by NOF CORPORATION) . Each of these heat polymerization initiators may be used alone or two or more of these may be used in combination.

The light-curable adhesive and the heat-curable adhesive preferably further contain a radical polymerizable polyfunctional oligomer or monomer. A radical polymerizable polyfunctional oligomer or monomer improves photo-curability or heat-curability.
The polyfunctional oligomer or monomer is preferably one having a molecular weight of 10,000 or lower. It is more preferably one having a molecular weight of 5,000 or lower and including 2 to 20 radical polymerizable unsaturated bonds in its molecule for efficient three-dimensional cross-linking of a pressure-sensitive agent layer by heat or light application.

Examples of the polyfunctional oligomer or monomer include trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, and methacrylates similar thereto. Examples thereof further include 1,4-butylene glycol diacrylate, 1,6-hexanediol diacrylate, polyethylene glycol diacrylate, commercially available oligoester acrylate, and methacrylates similar thereto. Each of these polyfunctional oligomers and monomers may be used alone or two or more of these may be used in combination.

The adhesive composition of the present invention contains one of the tetrazole compounds represented by the formulas (1) to (3). The tetrazole compounds represented by the formulas (1) to (3) generate a gas (nitrogen gas) by light application, whereas it has high heat resistance such that the compound is not decomposed at temperature as high as about 200°C.
In the formulas (1) to (3), $R^1$ and $R^2$ each represent hydrogen, a hydroxy group, an amino group, or a C1-C7 alkyl group, alkene group, phenyl group, or mercapto group. The C1-C7 alkyl group, alkene group, phenyl group, and mercapto group may be optionally substituted. If the groups such as an alkyl group are substituted, the substituents may be an amino group, an alkyl group, an alkene group, a phenyl group, a mercapto group, and the like.

Preferable among the tetrazole compounds represented by the formulas (1) to (3) is a tetrazole compound having a maximum molar extinction coefficient at a wavelength of 250 to 400 nm (hereinafter, also referred to as "$\varepsilon_{max}$ (250-400)") of 100 or higher and a nonvolatile matter component measured using a thermobalance after heating the compound from 100°C to 200°C (hereinafter, also referred to simply as "nonvolatile matter component") of 80% or higher. This is because such a tetrazole compound has very good heat resistance, and it easily generates a gas (nitrogen gas) even in the case of applying light using a relatively low-output light source (e.g. ultraviolet rays or white light). More preferable is a tetrazole compound having a maximum molar extinction coefficient at a wavelength of 270 to 400 nm (hereinafter, also referred to as "$\varepsilon_{max}$(270-400)") of 100 or higher.

The term "molar extinction coefficient" herein means a value determined as follows: 10 mg of a tetrazole compound is dissolved in a mixed solvent of methyl alcohol (5 mL) and a 1 N solution (5 mL) of sodium hydroxide in water; the absorption spectrum of the solution at a wavelength range of 200 to 600 nm is measured using a spectrophotometer (e.g. U-3000 produced by Hitachi, Ltd.); and the coefficient is calculated using the absorbance obtained from the spectrum based on the following equation:

$$\varepsilon = A/c \times d$$

wherein $\varepsilon$ is a molar extinction coefficient; A is an absorbance; c is a molar concentration; and d is a cell thickness.
The phrase "a maximum value of a molar extinction coefficient at a wavelength of 250 to 400 nm is 100 or higher" herein means that a molar extinction coefficient at any wavelength between 250 nm and 400 nm is 100 or higher, and the molar extinction coefficient needs not to have its peak at the wavelength between 250 nm and 400 nm.

The nonvolatile matter component may be determined as follows, for example: 5 to 10 mg of a tetrazole compound is placed on an aluminum pan of a thermobalance (e.g. TG/DTA 6200, Seiko Instruments inc.); the compound is heated from normal temperature (30°C) to 400°C in the air atmosphere (flow rate: 200 mL/min), at a temperature increasing rate of 5°C/min; and the nonvolatile matter component is measured.
Here, the reason why the measurement is performed "from 100°C" is to avoid influence of water adsorbed on the tetrazole compound.

Salts of the tetrazole compounds represented by the formulas (1) to (3) also easily generate nitrogen gas by light application because they each have a skeleton derived from the corresponding tetrazole compound represented

by one of the formulas (1) to (3).
The salts of the tetrazole compounds represented by the formulas (1) to (3) are not particularly limited, and examples thereof include sodium salts, potassium salts, and ammonium salts.
In the case that the tetrazole compounds represented by the formulas (1) to (3) each exist in a form of salt, the salts are represented by the following corresponding formulas (1') to (3').

[Chem. 2]

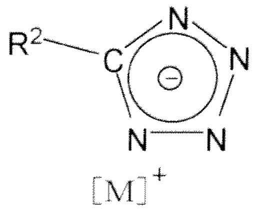

(1')

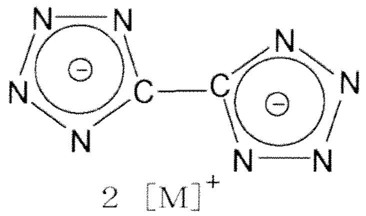

(2')

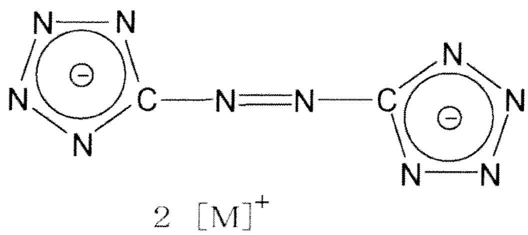

(3')

Each of the salts of the tetrazole compounds represented by the formulas (1') to (3') are easily prepared by mixing the corresponding tetrazole compound represented by one of the formulas (1) to (3) and a basic compound in a container without any complicated synthesis route.
The basic compound is not particularly limited, and examples thereof include amines, hydrazine compounds, hydroxylated quaternary ammonium salts, and phosphine compounds.
The amines are not particularly limited, and any of primary amines, secondary amines, and tertiary amines may be used. In particular, the basic compound is preferably a monoalkylamine or a dialkylamine. A monoalkylamine or a dialkylamine can lower the polarity of any of the salts to be produced from the tetrazole compounds represented by the formulas (1') to (3'), resulting in high solubility in the adhesive component. It is more preferably a C6-C12 monoalkylamine or dialkylamine.

In the case of using, as the adhesive component, a curable adhesive whose elastic modulus increases in response to stimulus, the tetrazole compound represented by one of the formulas (1) to (3) or its salt is preferably dissolved in the adhesive component. If the tetrazole compound represented by one of the formulas (1) to (3) or its salt is dissolved in the adhesive, such a compound itself does not serve as a foaming core, and most part of the generated

gas is released from the adhesive component to the interface with the adherend. As a result, more secure detachment can be achieved. Therefore, any of the salts of the tetrazole compounds represented by the formulas (1') to (3') with higher solubility are more preferably used.

The tetrazole compound represented by the formula (1) or its salt is not particularly limited. Specific examples thereof include 1H-tetrazole, 5-phenyl-1H-tetrazole, 5-amino-1H-tetrazole, 5-methyl-1H-tetrazole, 1-methyl-5-mercaptotetrazole, 1-methyl-5-ethyl-tetrazole, 1-(dimethylaminoethyl)-5-mercaptotetrazole, 1H-5-hydroxy-tetrazole, 1-methyl-5-ethyltetrazole, 1-propyl-5-methyl-tetrazole, 1-phenyl-5-hydroxytetrazole, 1-phenyl-5-mercaptotetrazole, 1-(p-ethoxyphenyl)-5-mercaptotetrazole, 1-(4-benzamide)-5-mercaptotetrazole, 5-tolyl tetrazole, 5-phenyl tetrazole, 5-aminotetrazole monohydrate, 5-(m-aminophenyl)tetrazole, 5-acetamidetetrazole, N-(1H-tetrazol-5-yl)-n-octanamide, 1-cyclohexyl-5-chlorobutyltetrazole, 1-(m-acetoaminophenyl)-5-mercaptotetrazole, 1-methyl-5-mercaptotetrazole, 1-(4-carboxyphenyl)-5-mercaptotetrazole, 1-methyl-5-ethyltetrazole, 5-aminomethyl-1H-tetrazole, and 4,5-di-(tetrazolyl)-[1,2,3]triazole.

The tetrazole compound represented by the formula (2) or its salt is not particularly limited. Specific examples thereof include a 5,5'-bistetrazole diammonium salt, a 5,5'-bistetrazole disodium salt, and a 5,5'-bistetrazole dipiperazinium salt.

The tetrazole compound represented by the formula (3) or its salt is not particularly limited. Specific examples thereof include 5,5-azobis-1H-tetrazole, a compound of 5,5-azobis-1H-tetrazole and guanidine, and a compound of 5,5-1H-azobistetrazole and methyl guanidine.

Of the tetrazole compounds represented by the formulas (1) to (3) or their salts, examples of those having a $\varepsilon_{max}$(250-400) of 100 or higher, a $\varepsilon_{max}$(270-400) of 100 or higher, and a nonvolatile matter component of 80% or higher include 5-phenyl-1H-tetrazole (compound of formula (4), $\varepsilon_{max}$(250-400): 401, $\varepsilon_{max}$(270-400): 401, nonvolatile matter component: 98%), 4,5-ditetrazolyl-[1,2,3]triazole (compound of formula (5), $\varepsilon_{max}$(250-400): 629, $\varepsilon_{max}$(270-400): 605, nonvolatile matter component: 85%), 1-(p-ethoxyphenyl)-5-mercaptotetrazole (compound of formula (6), $\varepsilon_{max}$(250-400): 718, $\varepsilon_{max}$(270-400): 718, nonvolatile matter component: 83%), 1-(4-benzamide)-5-mercaptotetrazole (compound of formula (7), $\varepsilon_{max}$(250-400): 713, $\varepsilon_{max}$(270-400): 713, nonvolatile matter component: 82%), 5-tolyltetrazole (compound of formula (8), $\varepsilon_{max}$(250-400): 368, $\varepsilon_{max}$(270-400): 368, nonvolatile matter component: 99%), 2-(5-tetrazoyl)aniline (compound of formula (9), $\varepsilon_{max}$(250-400): 372, $\varepsilon_{max}$(270-400): 372, nonvolatile matter component: 99%), 5-(m-aminophenyl) tetrazole (compound of formula (10), $\varepsilon_{max}$(250-400): 301, $\varepsilon_{max}$(270-400): 301, nonvolatile matter component: 100%), 5-acetamide tetrazole (compound of formula (11), $\varepsilon_{max}$(250-400): 262, $\varepsilon_{max}$(270-400): 258, nonvolatile matter component: 100%), N-(1H-tetrazol-5-yl)-n-octanamide (compound of formula (12), $\varepsilon_{max}$(250-400): 562, $\varepsilon_{max}$(270-400): 428, nonvolatile matter component: 98%), and 1-cyclohexyl-5-chlorobutyl tetrazole (compound of formula (13), $\varepsilon_{max}$(250-400): 304, $\varepsilon_{max}$(270-400): 262, nonvolatile matter component: 82%).

[Chem. 3]

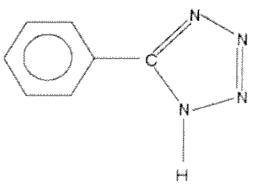
(4)

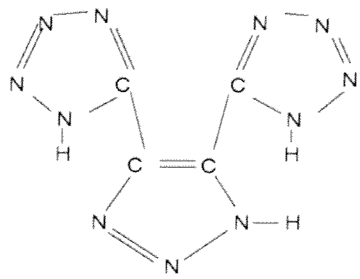
(5)

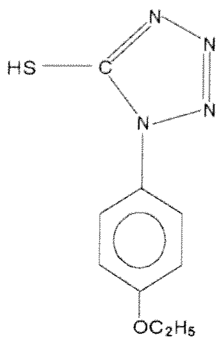
(6)

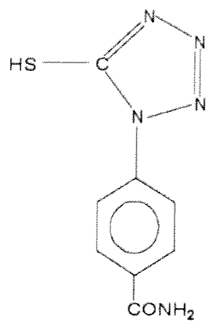
(7)

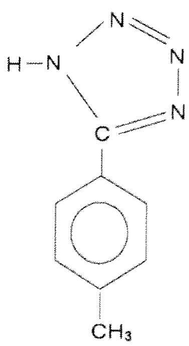
(8)

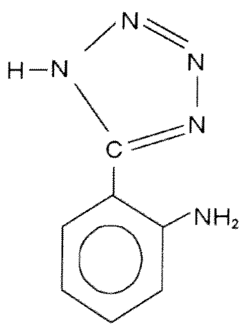
(9)

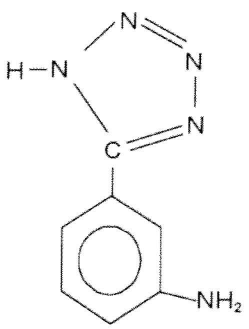
(10)

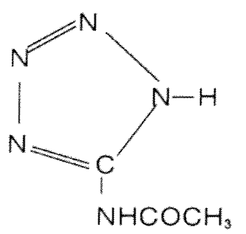
(11)

[Chem. 4]

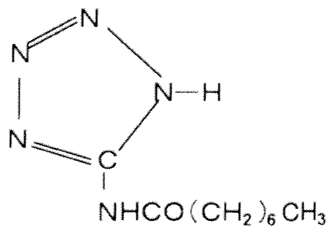

(1 2)

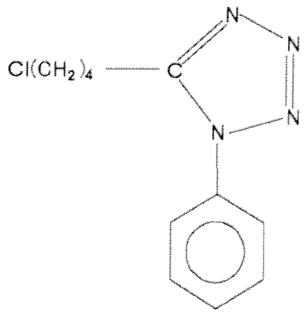

(1 3)

Of the tetrazole compounds represented by the formulas (1) to (3) or their salts, examples of those having a $\varepsilon_{max}$(250-400) of 100 or higher and a nonvolatile matter component of 80% or higher although it has a $\varepsilon_{max}$(270-400) less than 100 include bistetrazole piperazine salt (compound of formula (14), $\varepsilon_{max}$(250-400): 606, nonvolatile matter component: 98%), bistetrazole ammonium salt (compound of formula (15), $\varepsilon_{max}$(250-400): 473, nonvolatile matter component: 99%), bistetrazole disodium salt (compound of formula (16), $\varepsilon_{max}$(250-400): 320, nonvolatile matter component: 100%), bistetrazole monohydrate (compound of formula (17), $\varepsilon_{max}$(250-400): 402, nonvolatile matter component: 98%), bistetrazole monoammonium (compound of formula (18), $\varepsilon_{max}$(250-400): 506, nonvolatile matter component: 97%), 5-aminotetrazole monohydrate (compound of formula (19), $\varepsilon_{max}$(250-400): 299, nonvolatile matter component: 83%), and 5-aminomethyl-1H-tetrazole (compound of formula (20), $\varepsilon_{max}$(250-400): 282, nonvolatile matter component: 82%).

[Chem. 5]

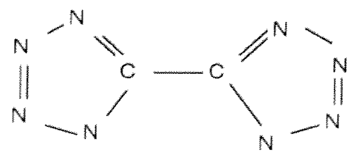 2 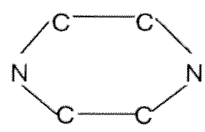 (14)

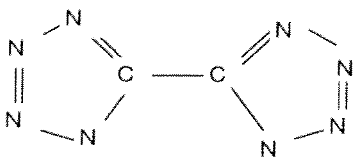
$2NH_3$ (15)

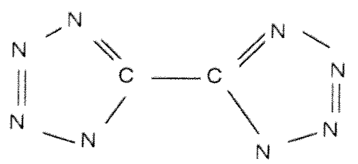 2Na (16)

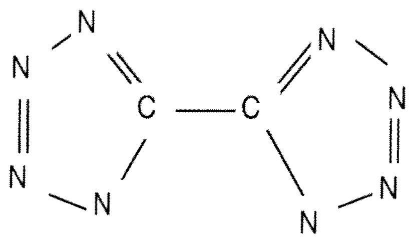 (17)

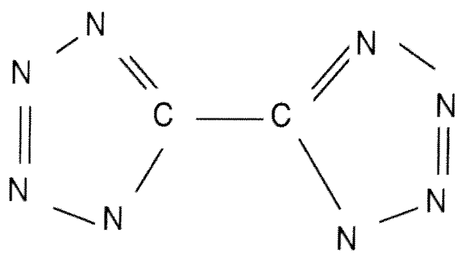 $1NH_3$ (18)

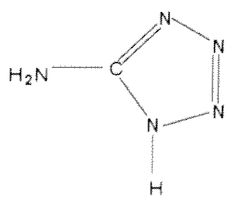 $H_2O$ (19)

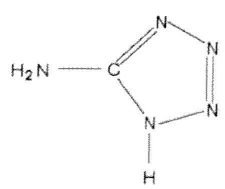 (20)

Examples of the tetrazole compound further include 1-methyl-5-mercaptotetrazole (compound of formula (21), $\varepsilon_{max}$(250-400): 364, $\varepsilon_{max}$(270-400): 364, nonvolatile matter component: 80%), a salt of 5,5-azobis-1H-tetrazole and diguanidine (ABG, compound of formula (22), $\varepsilon_{max}$(250-400): 938, $\varepsilon_{max}$(270-400): 938, nonvolatile matter component: 55%), 1-(m-acetoaminophenyl)-5-mercaptotetrazole (compound of formula (23), $\varepsilon_{max}$(250-400) of 276, $\varepsilon_{max}$(270-400) of 756, nonvolatile matter component: 47%), 1-(4-hydroxyphenyl)-5-mercaptotetrazole (compound of formula (24), $\varepsilon_{max}$ (250-400): 576, $\varepsilon_{max}$(270-400): 576, nonvolatile matter component: 44%), 1-phenyl-5-mercaptotetrazole (compound of formula (25), $\varepsilon_{max}$(250-400): 574, $\varepsilon_{max}$(270-400): 574, nonvolatile matter component: 47%), 1-methyl-5-mercaptotetrazole (compound of formula (26), $\varepsilon_{max}$(250-400): 363, $\varepsilon_{max}$(270-400): 364, nonvolatile matter component: 77%), 1-(4-carboxyphenyl)-5-mercaptotetrazole (compound of formula (27), $\varepsilon_{max}$(250-400): 726, $\varepsilon_{max}$(270-400): 726, nonvolatile matter component: 40%), 5-methyltetrazole (compound of formula (28), $\varepsilon_{max}$(250-400): less than 100, $\varepsilon_{max}$(270-400):

less than 100, nonvolatile matter component: 82%), a salt of 5,5-1H-azobistetrazole and methylguanidine (ABAG, compound of formula (29), $\varepsilon_{max}$(250-400): 1032, $\varepsilon_{max}$(270-400): 1032, nonvolatile matter component: 40%), 1-methyl-5-ethyltetrazole (compound of formula (30), $\varepsilon_{max}$(250-400): less than 100, $\varepsilon_{max}$(270-400): less than 100, nonvolatile matter component: 60%), and 5-aminomethyl-1H-tetrazole (compound of formula 31), $\varepsilon_{max}$(250-400): less than 100, $\varepsilon_{max}$(270-400): less than 100, nonvolatile matter component: 100%).

[Chem. 6]

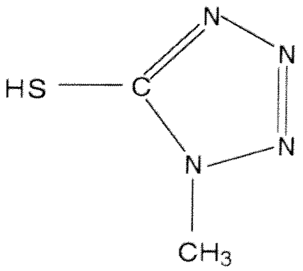

(2 1)

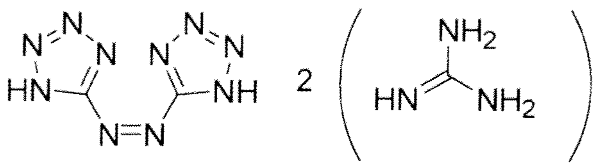

(2 2)

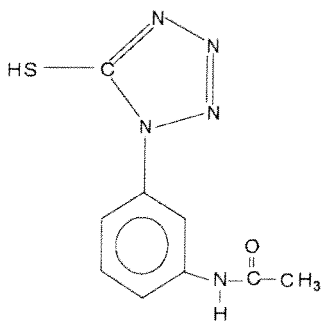

(2 3)

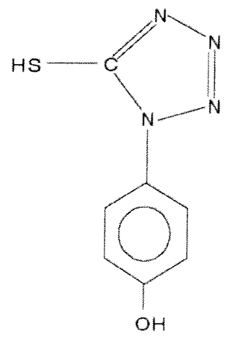

(2 4)

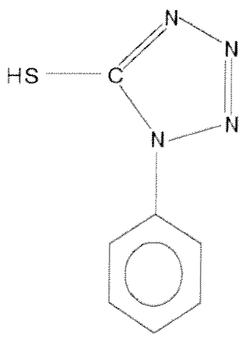

(2 5)

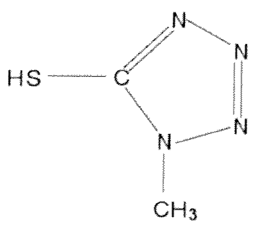

(2 6)

[Chem. 7]

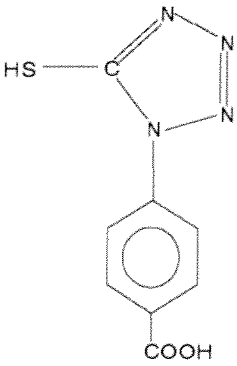

(27)

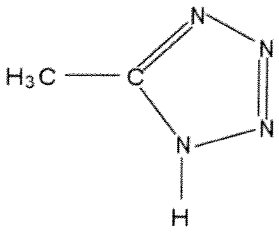

(28)

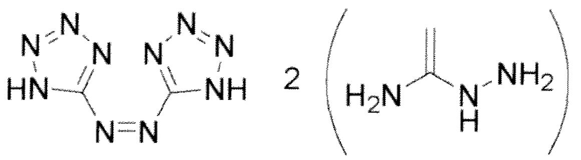

(29)

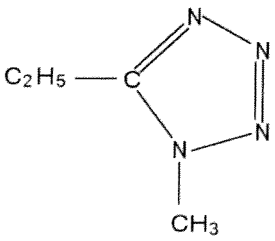

(30)

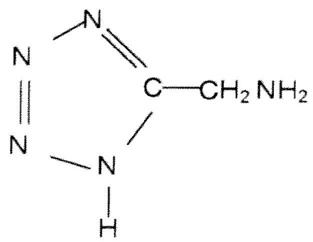

(31)

With respect to the amount of the tetrazole compound represented by one of formulas (1) to (3) or its salt, the lower limit thereof is preferably 5 parts by weight, whereas the upper limit is preferably 50 parts by weight, for 100 parts by weight of the adhesive component. If the amount of the tetrazole compound represented by one of the formulas (1) to (3) or is salt is less than 5 parts by weight, light application may generate less nitrogen gas and the adhesive composition may not be well detached. If the amount is more than 50 parts by weight, the compound may not be completely dissolved into the adhesive component, and the adhesive force may be deteriorated. The lower limit of the amount of the tetrazole compound represented by one of the formulas (1) to (3) or its salt is more preferably 10 parts by weight, whereas the upper limit thereof is more preferably 30 parts by weight.

The adhesive composition of the present invention may contain a photosensitizer.

The photosensitizer enhances light stimulus to the tetrazole compounds represented by the formulas (1) to (3) or their salts. Thus, it enables to release a gas by weaker light application. In addition, a gas can be released by light within a wider wavelength range.

The photosensitizer is not particularly limited as long as it is excellent in heat resistance.

Examples of the photosensitizer with excellent heat resistance include polycyclic aromatic compounds having at least one alkoxy group. Preferable among these are substituted alkoxy polycyclic aromatic compounds having an alkoxy group that is partially substituted with a glycidyl group or a hydroxy group. These photosensitizers are high in sublimation resistance, and thus can be used under high-temperature conditions. Further, partial substitution of the alkoxy group with a glycidyl group or a hydroxy group increases the solubility of the photosensitizer into the adhesive component, so that bleed out thereof can be prevented.

The polycyclic aromatic compound is preferably an anthracene derivative. The alkoxy group is preferably a C1-C18 group, and more preferably a C1-C8 group.

Examples of the polycyclic aromatic compound having at least one alkoxy group include anthracene derivatives such as 9,10-dimethoxyanthracene, 2-ethyl-9,10-dimethoxyanthracene, 2-t-butyl-9,10-dimethoxyanthracene, 2,3-dimethyl-9,10-dimethoxyanthracene, 9-methoxy-10-methylanthracene, 9,10-diethoxyanthracene, 2-ethyl-9,10-diethoxyanthracene, 4-t-butyl-9,10-diethoxyanthracene, 2,3-dimethyl-9,10-diethoxyanthracene, 9-ethoxy-10-methylanthracene, 9,10-dipropoxyanthracene, 2-ethyl-9,10-dipropoxyanthracene, 2-t-butyl-9,10-dipropoxyanthracene, 2,3-dimethyl-9,10-dipropoxyanthracene, 9-isopropoxy-10-methylanthracene, 9,10-dibutoxyanthracene, 9,10-dibenzyloxyanthracene, 2-ethyl-9,10-dibenzyloxyanthracene, 2-t-butyl-9,10-dibenzyloxyanthracene, 2,3-dimethyl-9,10-dibenzyloxyanthracene, 9-benzyloxy-10-methylanthracene, 9,10-di-α-methylbenzyloxyanthracene, 2-ethyl-9,10-di-α-methylbenzyloxyanthracene, 2-t-butyl-9,10-di-α-methylbenzyloxyanthracene, 2,3-dimethyl-9,10-di-α-methylbenzyloxyanthracene, 9-(α-methylbenzyloxy)-10-methylanthracene, 9,10-di(2-hydroxyethoxy)anthracene, and 2-ethyl-9,10-di(2-carboxyethoxy)anthracene.

Examples of the substituted alkoxy polycyclic aromatic compound having an alkoxy group partially substituted with a glycidyl group or a hydroxy group include 9,10-di(glycidyloxy)anthracene, 2-ethyl-9,10-di(glycidyloxy)anthracene, 2-t-butyl-9,10-di(glycidyloxy)anthracene, 2,3-dimethyl-9,10-di(glycidyloxy)anthracene, 9-(glycidyloxy)-10-methylanthracene, 9,10-di(2-vinyloxyethoxy)anthracene, 2-ethyl-9,10-di(2-vinyloxyethoxy)anthracene, 2-t-butyl-9,10-di(2-vinyloxyethoxy)anthracene, 2,3-dimethyl-9,10-di(2-vinyloxyethoxy)anthracene, 9-(2-vinyloxyethoxy)-10-methylanthracene, 9,10-di(3-methyl-3-oxetanylmethoxy)anthracene, 2-ethyl-9,10-di(3-methyl-3-oxetanylmethoxy)anthracene, 2-t-butyl-9,10-di(3-methyl-3-oxetanylmethoxy)anthracene, 2,3-dimethyl-9,10-di(3-methyl-3-oxetanylmethoxy)anthracene, 9-(3-methyl-3-oxetanylmethoxy)-10-methylanthracene, 9,10-di(p-epoxyphenylmethoxy)anthracene, 2-ethyl-9,10-di(p-epoxyphenylmethoxy)anthracene, 2-t-butyl-9,10-di(p-epoxyphenylmethoxy)anthracene, 2,3-dimethyl-9,10-di(p-epoxyphenylmethoxy)anthracene, 9-(p-epoxyphenylmethoxy)-10-methylanthracene, 9,10-di(p-vinylphenylmethoxy)anthracene, 2-ethyl-9,10-di(p-vinylphenylmethoxy)anthracene, 2-t-butyl-9,1-di(p-vinylphenylmethoxy)anthracene, 2,3-dimethyl-9,10-di(p-vinylphenylmethoxy)anthracene, 9-(p-vinylphenylmethoxy)-10-methylanthracene, 9,10-di(2-hydroxyethoxy) anthracene, 9,10-di(2-hydroxypropoxy)anthracene, 9,10-di(2-hydroxybutoxy)anthracene, 9,10-di(2-hydroxy-3-butoxypropoxy)anthracene, 9,10-di(2-hydroxy-3-(2-ethylhexyloxy)propoxy)anthracene, 9,10-di(2-hydroxy-3-allyloxypropoxy) anthracene, 9,10-di(2-hydroxy-3-phenoxypropoxy)anthracene, and 9,10-di(2,3-dihydroxypropoxy)anthracene.

With respect to the amount of the photosensitizer, the lower limit thereof is preferably 0.05 parts by weight, whereas the upper limit thereof is preferable 10 parts by weight, for 100 parts by weight of the adhesive component. If the amount of the photosensitizer is less than 0.05 parts by weight, the enhancing effect may be insufficient. If the amount is more than 10 parts by weight, more residues derived from the photosensitizer may be generated, so that detachment may not be sufficiently performed. The lower limit of the amount of the photosensitizer is more preferably 0.1 parts by weight, whereas the upper limit thereof is more preferably 5 parts by weight.

The adhesive composition of the present invention may appropriately further contain various polyfunctional compounds which are blended into common pressure-sensitive agents, such as isocyanate compounds, melamine compounds, and epoxy compounds, if necessary, in order to adjust the cohesive force as the pressure-sensitive agent. The adhesive composition of the present invention may contain known additives such as a plasticizer, resin, a surfactant, wax, and fine particle filler.

The adhesive composition of the present invention has high adhesive strength and is easily detached by light application or heating. Since the adhesive composition is excellent in heat resistance, it can be used in applications including a treatment at a temperature not lower than 200°C, such as fixing of a wafer to a supporting plate in TSV production.

The adhesive composition of the present invention can be used for various adhesive products.

Examples of the adhesive products include those in which the adhesive composition of the present invention is used as a binder resin, such as adhesives, pressure-sensitive agents, paints, coating agents, and sealants; and pressure-sensitive tapes in which the adhesive composition of the present invention is used as a pressure-sensitive agent, such as single-side pressure-sensitive tapes, double-sided pressure-sensitive tapes, and non-support tapes (self-supporting tapes).

An adhesive tape having an adhesive layer which comprises the adhesive composition of the present invention on one face of a material is also one aspect of the present invention.

An adhesive tape having adhesive layers each of which comprises the adhesive composition of the present invention on the respective faces of a base material is also one aspect of the present invention.

The adhesive tape of the present invention can be suitably used as a back-grind tape upon processing a semiconductor wafer; a dicing tape; a tape for supporting fragile members such as very thin glass substrates and easy-to-warp members such as plastic films and core-less FPC substrates; and the like.

Examples of the base material include sheets of transparent resin such as acryl, olefin, polycarbonate, vinyl chloride, ABS, polyethylene terephthalate (PET), polyethylene naphthalate (PEN), nylon, urethane, and polyimide; mesh-structured sheets; and perforated sheets.

The adhesive tape of the present invention may be used for attaching supporting plate in order to protect a semiconductor wafer when the semiconductor wafer is chemically treated, heat-treated, or exothermically treated, for

example. After these treatments, the supporting plate can be easily detached from the semiconductor wafer by light irradiation.

The present invention also includes as one aspect a method for treating a semiconductor wafer, the method comprising the steps of: attaching a semiconductor wafer and a supporting plate using the adhesive of the present invention; chemically treating, heat-treating, or exothermically treating the semiconductor wafer in a state of being attached with the supporting plate; thereafter, applying light to the adhesive tape to generate a gas from a tetrazole compound in the adhesive layer; and detaching the supporting plate and the adhesive tape from the semiconductor wafer.

The adhesive tape of the present invention can be used, for example, for attaching a supporting plate in order to protect a semiconductor wafer when a through hole with an electrode is formed on the semiconductor wafer. After these treatments, the supporting plate is easily detached from the semiconductor wafer by light application.

The present invention also includes as one aspect a method for producing a TSV wafer, the method comprising the steps of: attaching a semiconductor wafer that has a groove portion and a supporting plate using the adhesive tape of the present invention; grinding the face of the semiconductor wafer opposite to the face where the supporting plate is attached, whereby the groove portion is penetrated to form a through hole; forming an electrode portion around the through hole of the semiconductor wafer; after forming the electrode portion, applying light to the adhesive tape to generate a gas from a tetrazole compound in the adhesive layer; and detaching the supporting plate and the adhesive tape from the semiconductor wafer.

- Advantageous Effects of Invention

The present invention can provide an adhesive composition having high adhesive strength as well as being easily detachable and having excellent heat resistance, an adhesive tape comprising the adhesive composition, a method for treating a semiconductor wafer using the adhesive tape, and a method for producing a TSV wafer.

DESCRIPTION OF EMBODIMENTS

The following will describe the embodiments of the present invention referring to, but not limited to, examples.

(Example 1)

A reactor equipped with a thermometer, a stirrer, and a condenser was prepared. This reactor was charged with 2-ethylhexyl acrylate (94 parts by weight), acrylic acid (1 part by weight), 2-hydroxyethyl acrylate (5 parts by weight), lauryl mercaptan (0.01 parts by weight), and ethyl acetate (180 parts by weight), and then heated to initiate reflux. Next, 1,1-bis(t-hexylperoxy)-3,3,5-trimethylcyclohexane (0.01 parts by weight) was put into the reactor as a polymerization initiator, and polymerization was started under reflux. Thereafter, 1,1-bis(t-hexylperoxy)-3,3,5-trimethylcyclohexane (each 0.01 parts by weight) was added one hour after and two hours after the start of the polymerization. Four hours after the start of the polymerization, t-hexyl peroxypivalate (0.05 parts by weight) was added to continue the polymerization reaction. Finally, eight hours after the start of the polymerization, an acrylic copolymer having a solids content of 55% by weight and a weight average molecular weight of 600,000 was obtained.

Then, 2-isocyanatoethyl methacrylate (3.5 parts by weight) was added to react with the ethyl acetate solution containing the obtained acrylic copolymer (resin solids content: 100 parts by weight). To the ethyl acetate solution after the redaction (resin solids content: 100 parts by weight) was added a photo polymerization initiator (0.1 parts by weight, ESACURE ONE, Nihon SiberHegner K.K.) and a polyisocyanate cross-linker (2.5 parts by weight, CORONATE L45, Nippon Polyurethane Industry Co., Ltd.), and they were mixed to prepare an ethyl acetate solution of an adhesive (1).

The ethyl acetate solution of the adhesive (1) (resin solids content: 100 parts by weight), 5-phenyl-1H-tetrazole (20 parts by weight), and 9,10-diglycidyloxyanthracene (1 part by weight) as a photosensitizer were mixed to provide an adhesive composition.

A 50-μm-thick transparent polyethylene naphthalate film was prepared and both faces of the film were corona-treated. Then, the obtained adhesive composition was applied to one face of the film using a doctor knife so as to have a dry thickness of 30 μm. The workpiece was heated for 5 minutes at 110°C, so that the applied solution was dried. Next, the adhesive composition was applied to the other face of the polyethylene naphthalate film using a doctor knife so as to have a dry thickness of 30 μm. The workpiece was heated for 5 minutes at 110°C, so that the applied solution was dried. Finally, the workpiece was left to cure for 3 days at 40°C, so that an adhesive tape having adhesive layers on the respective faces was obtained.

(Examples 2 to 28)

Except that the corresponding tetrazole compound shown in Table 1 or 2 was used instead of 5-phenyl-1H-tetrazole, an adhesive composition and an adhesive tape were obtained in the same manner as in Example 1.

(Comparative Example 1)

Except that 5-phenyl-1H-tetrazole not used, an adhesive composition and an adhesive tape were obtained in the same manner as in Example 1.

(Comparative Example 2)

Except that 2,2'-azobis-(N-butyl-2-methylpropionamide) (20 parts by weight) was used instead of 5-phenyl-1H-tetrazole (20 parts by weight) and that diethylthioxanthone (3 parts by weight) used instead of 9,10-diglycidyloxyanthracene (1 part by weight), an adhesive composition and an adhesive tape were obtained in the same manner as in Examples 1.

(Comparative Example 3)

A reactor equipped with a thermometer, a stirrer, and a condenser was prepared. This reactor was charged with 2-ethylhexyl acrylate (94 parts by weight), acrylic acid (1 part by weight), 2-hydroxyethyl acrylate (5 parts by weight), lauryl mercaptan (0.01 parts by weight), and ethyl acetate (180 parts by weight), and then heated to initiate reflux. Next, 1,1-bis(t-hexylperoxy)-3,3,5-trimethylcyclohexane (0.01 parts by weight) was put into the reactor as a polymerization initiator, and polymerization was started under reflux. Thereafter, 1,1-bis(t-hexylperoxy)-3,3,5-trimethylcyclohexane (each 0.01 parts by weight) was added one hour after and two hours after the start of the polymerization. Four hours after the start of the polymerization, t-hexyl peroxypivalate (0.05 parts by weight) was added to continue the polymerization redaction. Finally, eight hours after the start of the polymerization, an acrylic copolymer having a solids content of 55% by weight and a weight average molecular weight of 600,000 was obtained.
The obtained acrylic pressure-sensitive agent (solids content: 100 parts by weight) and Microsphere F-50D (50 parts by weight, Matsumoto Yushi-Seiyaku Co., Ltd.) were mixed to provide an adhesive composition.
A 50-μm-thick transparent polyethylene naphthalate film was prepared and both faces of the film were corona-treated. Then, the obtained adhesive composition was applied to one face of the film using a doctor knife so as to have a dry thickness of 30 μm. The workpiece was heated for 5 minutes at 110°C, so that the applied solution was dried. Next, the adhesive composition was applied to the other face of the polyethylene naphthalate film using a doctor knife so as to have a dry thickness of 30 μm. The workpiece was heated for 5 minutes at 110°C, so that the applied solution was dried. Finally, the workpiece was left to cure for 3 days at 40°C, so that an adhesive tape having adhesive layers on the respective faces was obtained.

(Evaluation)

The tetrazole compounds used in the examples and the comparative examples, and the adhesive tapes obtained in the examples and the comparative examples were evaluated as follows.
Tables 1 and 2 show the results.

(1) Measurement of molar extinction coefficient of tetrazole compound

The tetrazole compound (10 mg) was dissolved in a mixed solvent of methyl alcohol (5 mL) and 1 N aqueous solution (5 mL) of sodium hydroxide, and the absorption spectrum of the obtained solution was measured using U-3000 (Hitachi, Ltd.). Based on the absorbance in the obtained absorption spectrum, the molar extinction coefficient determined by the following formula:

$$\varepsilon = A/c \times d$$

wherein ε represents molar extinction coefficient; A represents absorbance; c represents molar concentration; and d represents cell thickness.
Within the wavelength range of 250 to 400 nm, the wavelength range in which the molar extinction coefficient is 100 or higher, the maximum molar extinction coefficient, and the wavelength at which the molar extinction coefficient is maximum were determined.

(2) Measurement of nonvolatile matter component of tetrazole compound

The tetrazole compound (5 to 10 mg) was placed on the aluminum pan of a thermobalance (TG/DTA6200, Seiko Instruments Inc.) and was heated from normal temperature (30°C) to 400°C in the air atmosphere (flow rate: 200 mL/min), at an increasing rate of 5°C/min. The weight reduction ratio under the above conditions was measured.

(3) Evaluation of adhesiveness and detachability of adhesive tape before heat treatment

The adhesive tape was cut into a circular shape with a diameter of 20 cm, and the cut tape was attached to a silicon wafer with a diameter of 20 cm and a thickness of about 750 μm. A glass plate with a diameter of 20 cm and a thickness of 1 mm was attached to the tape opposite to the side that faces the silicon wafer.
The adhesiveness was evaluated as follows: the silicon wafer was placed on an adsorbing stage such that the glass faced upward, and then the glass edge was pulled using a suction cup. The case where glass was not detached at all was evaluated as "o"; the case where the glass is relatively easily detached as "Δ"; and the cause where the glass is detached substantially without difficulty as "×".
Then, ultraviolet rays were applied to the glass plate surface for two minutes using an ultra-high-pressure mercury lamp from the glass plate side while the irradiance was adjusted so that the radiation intensity was 400 $mW/cm^2$ in 365-nm conversion. The detachability after light application was evaluated as follows: the silicon wafer was placed on an adsorbing stage such that the glass faced upward, and then the glass edge was pulled using a suction cup. The case where the glass was detached without any difficulty was evaluated as "o"; the case where the glass was detached with difficulty as "Δ"; and the case where the glass was not detached at all as "×".

(4) Evaluation of adhesiveness and detachability of adhesive tape after heat treatment

The adhesive tape was cut into a circular shape with a diameter of 20 cm, and the cut tape was attached to a silicon wafer with a diameter of 20 cm and a thickness of about 750 μm. A glass plate with a diameter of 20 cm and a thickness of 1 mm was attached to the tape opposite to the side that faces the silicon wafer. This laminate was heated for one hour at 200°C, and then cooled down to room temperature.
The adhesiveness was evaluated as follows: the surface after heating was visually observed; then, the silicon wafer was placed on an adsorbing stage such that the glass faced upward, and then the glass edge was pulled using a suction cup. The case where no floating up was observed on the whole surface and the glass was not detached at all even by pulling up was evaluated as "oo"; the case where the ratio of the floating-up area was 3% or smaller to the whole area the glass was not detached even by pulling up as "o"; the case where the ratio of the floating-up area was 3% or greater and 10% or smaller to the whole area and the glass was not detached even by pulling up as "Δ"; and the case where the glass was easily detached as "×".
Then, ultraviolet rays were applied to the glass plate surface for two minutes using an ultra-high-pressure mercury lamp from the glass plate side while the irradiance was adjusted so that the radiation intensity was 400 $mW/cm^2$ in 365-nm conversion. The case where the wafer and the adhesive layer were detached from the interface therebetween and no adhesive remained on the wafer was evaluated as "oo"; the case where the wafer and the adhesive layer were detached from the interface therebetween and slight stain remained on the wafer (the stain was removed by washing) as "o"; the case where the wafer and the adhesive layer were detached and stain remained on the wafer (the stain was removed by washing) as "Δ"; and the case where the wafer and the adhesive layer were not detached at all as "×".
The same evaluation was performed on the sample after heating treatment at 200°C for 4 hours.
[Table 1]

| | Evaluation of compound | | | | | Evaluation of adhesive tape | | | | | |
|---|---|---|---|---|---|---|---|---|---|---|---|
| | Compound | Optical properties at a wavelength of 250 to 400 nm | | | Heat property | Before heat treatment | | After heat treatment | | | |
| | | | | | | | | 200 C 1 hour | | 200 C 4 hours | |
| | | Wavelength range within which molar extinction coefficient is 100 or higher (nm) | Maximum molar extinction coefficient | Wavelength at which molar extinction coefficient is maximum (nm) | Nonvolatile matter component under 200°C heating (%) | Adhesiveness | Detachability | Adhesiveness | Detachability | Adhesiveness | Detachability |
| Example 1 | 5-Phenyl-1H tetrazole | 291-250 | 401 | 287 | 98 | O | O | OO | OO | OO | OO |
| Example 2 | 4,5-Ditetrazolyl-[1,2,3] triazole | 466-250 | 629 | 257 | 85 | O | O | OO | OO | OO | OO |
| Example 3 | 1 (p-Ethoxyphenyl)-5-mercaptotetrazole | 342-250 | 718 | 301 | 83 | O | O | OO | OO | OO | OO |
| Example 4 | 1-(4-Benzamide)-5-mercaptotetrazole | 371-250 | 713 | 276 | 82 | O | O | OO | O | OO | OO |
| Example 5 | 5-Tolyltetrazole | 297-250 | 368 | 289 | 99 | O | O | OO | OO | OO | OO |
| Example 6 | 2-(5-Tetrazoylianiline | 295-250 | 372 | 288 | 99 | O | O | OO | OO | OO | OO |
| Example 7 | 5-(m-Aminophenyl) tetrazole | 297-250 | 301 | 289 | 100 | O | O | OO | OO | OO | OO |
| Example 8 | 5-Acetamide tetrazole | 279-250 | 262 | 264 | 100 | O | O | OO | OO | OO | OO |
| Example 9 | N-(1H-tetrazol-5-yl)-n-octanamide | 279-250 | 562 | 252 | 98 | O | O | OO | OO | OO | OO |
| Example 10 | 1-Cyclohexyl-5-chlorobutyl tetrazole | 301-250 | 304 | 252 | 95 | O | O | OO | OO | OO | OO |

[Table 2]

| | Compound | Evaluation of compound | | | | Evaluation of adhesive tape | | | | | |
|---|---|---|---|---|---|---|---|---|---|---|---|
| | | Optical properties at a wavelength of 250 to 400 nm | | | Heat property | Before heat treatment | | After heat treatment | | | |
| | | | | | | | | 200 C 1 hour | | 200 C 4 hours | |
| | | Wavelength range within which molar extinction coefficient is 100 or higher (nm) | Maximum molar extinction coefficient | Wavelength at which molar extinction coefficient is maximum (nm ) | Nonvolatile matter component under 200°C heating (%) | Adhesiveness | Detachability | Adhesiveness | Detachability | Adhesiveness | Detachability |
| Example 11 | Bistetrazole piperazine salt | 255-250 | 606 | 250 | 98 | ○ | ○ | ○○ | ○ | ○○ | ○ |
| Example 12 | Bistetrazole ammonium salt | 255-250 | 473 | 250 | 99 | ○ | ○ | ○○ | ○ | ○○ | ○ |
| Example 13 | Bistetrazole disodium salt | 255-250 | 380 | 250 | 100 | ○ | ○ | ○○ | ○ | ○○ | ○ |
| Example 14 | Bistetrazole monohydrate | 255-250 | 402 | 250 | 98 | ○ | ○ | ○○ | ○ | ○○ | ○ |
| Example 15 | Bistetrazole monoammonium | 255-250 | 506 | 250 | 97 | ○ | ○ | ○○ | ○ | ○○ | ○ |
| Example 16 | 5 -Aminotetrazole monohydrate | 261-250 | 299 | 256 | 83 | ○ | ○ | ○○ | ○○ | ○○ | ○○ |
| Example 17 | 5-Aminomethyl-1H-tetrazole | 260-250 | 282 | 254 | 82 | ○ | ○ | ○○ | ○○ | ○○ | ○○ |
| Example 18 | 1-Methyl-5-mercaptotetrazole | 310-250 | 364 | 269 | 80 | ○ | ○ | ○ | △ | △ | △ |
| Example 19 | 5,5-Azotes-1H-tetrazole and diguanidine salt | 192-250 | 938 | 287 | 55 | ○ | ○ | ○ | △ | △ | △ |
| Example 20 | 1-(m-Acetaminophenyl)-5-mercaptotetrazole | 348-250 | 764 | 268 | 47 | ○ | ○ | ○ | △ | △ | △ |
| Example 21 | 1-(4-Hydroxyphenyl)-5-mercaptotetrazole | 356-250 | 576 | 343 | 44 | ○ | ○ | ○ | △ | △ | △ |

(continued)

| | Compound | Evaluation of compound | | | | Evaluation of adhesive tape | | | | | |
|---|---|---|---|---|---|---|---|---|---|---|---|
| | | Optical properties at a wavelength of 250 to 400 nm | | | Heat property | Before heat treatment | | After heat treatment | | | |
| | | | | | | | | 200 C 1 hour | | 200 C 4 hours | |
| | | Wavelength range within which molar extinction coefficient is 100 or higher (nm) | Maximum molar extinction coefficient | Wavelength at which molar extinction coefficient is maximum (nm ) | Nonvolatile matter component under 200°C heating (%) | Adhesiveness | Detachability | Adhesiveness | Detachability | Adhesiveness | Detachability |
| Example 22 | 1-phenyl-5-mercaptotretazole | 345-250 | 574 | 294 | 47 | ○ | ○ | ○ | △ | △ | △ |
| Example 23 | 1-Methyl-5-mercaptotetrazole | 308-250 | 363 | 263 | 77 | ○ | ○ | ○ | △ | △ | △ |
| Example 24 | 1-(4-Carboxyphenyl)-5-mercaptotetrazole | 402-250 | 726 | 325 | 40 | ○ | ○ | ○ | △ | △ | △ |
| Example 25 | 5-Methyltetrazole | None | - | - | 82 | ○ | ○ | ○ | △ | ○ | △ |
| Example 26 | 5,5-1H-azobistetrazole and methyl guanidine salt | 480-250 | 1032 | 304 | 40 | ○ | ○ | ○ | △ | △ | △ |
| Example 27 | 1-Methyl-5-ethyltetrazole | None | - | - | 60 | ○ | ○ | ○ | △ | ○ | △ |
| Example 28 | 5-aminomethyl-1H-tetrazole | None | - | - | 100 | ○ | ○ | ○ | △ | ○ | △ |
| Comparative Example 1 | - | - | - | - | - | ○ | × | ○ | × | ○ | × |
| ComparativeExample 2 | 2,2'-Azobis-(N-butyl-2-methylproponamide) | - | - | - | - | ○ | ○ | × | - | × | - |
| Comparative Example 3 | Thermoexpandable microsphere | - | - | - | - | ○ | △ | × | - | × | - |

INDUSTRIAL APPLICABILITY

The present invention aims to provide an adhesive composition having high adhesive strength, as well as being easily detachable and having excellent heat resistance, an adhesives tape comprising the adhesives composition, a method for treating a semiconductor wafer using the adhesive tape, and a method for producing a TSV wafer.

## Claims

**1.** An adhesive composition, comprising:

an adhesive component; and
a tetrazole compound represented by the following formula (1), formula (2), or formula (3), or its salt:

[Chem. 1]

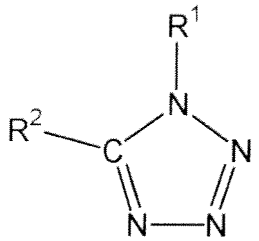

(1)

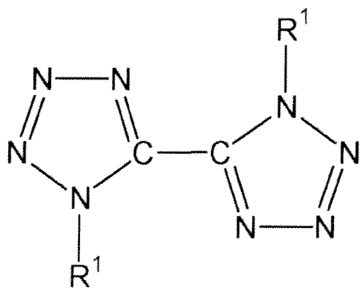

(2)

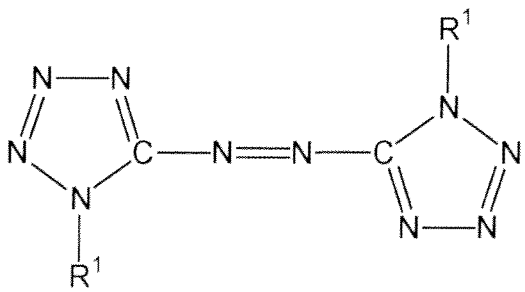

(3)

wherein $R^1$ and $R^2$ each represent hydrogen, a hydroxy group, an amino group, or a C1-C7 alkyl group, alkylene group, phenyl group, or mercapto group; and the C1-C7 alkyl group, alkylene group, phenyl group, and mercapto

group may be optionally substituted.

2. The adhesive composition according to claim wherein the tetrazole compound has a maximum molar extinction coefficient of 100 or higher at a wavelength of 250 to 400 nm, and has a nonvolatile matter component of 80% or higher which is measured using a thermobalance after heating of the compound from 100°C to 200°C.

3. The adhesive composition according to claim 1, wherein the tetrazole compound has a maximum molar extinction coefficient of 100 or higher at a wavelength of 270 to 400 nm, and has a nonvolatile matter component of 80% or higher which is measured using a thermobalance after heating of the compound from 100°C to 200°C.

4. The adhesive composition according to claim 1, 2, or 3, wherein the adhesive component contains a curable adhesive whose elastic modulus increases by stimulus.

5. The adhesive composition according to claim 1 , 2, 3, or 4, further comprising a photosensitizer.

6. The adhesive composition according to claim wherein the photosensitizer is a polycyclic aromatic compound having at least one alkoxy group.

7. The adhesives composition according to claim wherein the photosensitizer is a substituted alkoxy polycyclic aromatic compounds having an alkoxy group which is partially substituted by a glycidyl group or a hydroxy group.

8. An adhesive tape, comprising:

   a base material; and
   an adhesive layer which is disposed on one face of the base material and which comprises the adhesives composition according to claim 1, 2, 3, 4, 5, 6, or 7.

9. An adhesive tape, comprising:

   a base material; and
   adhesive layers which are disposed on the respective faces of the base material and each of which comprises the adhesive composition according to claim 1, 2, 3, 4, 5, 6, or 7.

10. A method for treating a semiconductor wafer, the method comprising the steps of:

   attaching a semiconductor wafer and a supporting plate using the adhesive tape according to claim 9;
   chemically treating, heat-treating, or exothermically treating the semiconductor wafer in a state of being attached to the supporting plate;
   applying light to the treated adhesive tape to generate a gas from a tetrazole compounds in an adhesive, layer; and
   detaching the supporting plate and the adhesive tape from the semiconductor wafer.

11. A method for producing a TSV wafer, the method comprising the steps of:

   attaching a semiconductor wafer having a groove portion and a supporting plate using the adhesive tape according to claim 9;
   grinding the face of the semiconductor wafer opposite to the face where the supporting plate is attached, whereby the groove portion is penetrated to have a through hole;
   forming an electrode portion around the through hole of the semiconductor wafer;
   applying light to the adhesive tape, after forming the electrode portion, to generate a gas from a tetrazole compound of an adhesive layer; and
   detaching the supporting plate and the adhesives tape from the semiconductor wafer.

**INTERNATIONAL SEARCH REPORT**

International application No.
PCT/JP2011/056460

A. CLASSIFICATION OF SUBJECT MATTER
*C09J201/00*(2006.01)i, *C09J7/02*(2006.01)i, *C09J11/06*(2006.01)i

According to International Patent Classification (IPC) or to both national classification and IPC

B. FIELDS SEARCHED

Minimum documentation searched (classification system followed by classification symbols)
C09J1/00-201/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2004-520667 A (JSR Corp.),<br>08 July 2004 (08.07.2004),<br>claims; examples<br>& WO 2002/39442 A2 & AU 200221202 A<br>& US 2003/008950 A1 & EP 1354316 A2<br>& BR 200115230 A & CN 1481554 A<br>& KR 2004-030455 A & IN 200300693 A | 1-5,8,9<br>6,7 |
| X<br>Y | JP 2002-536527 A (ENKEL KGAA),<br>29 October 2002 (29.10.2002),<br>claims; examples; paragraph [0017]<br>& DE 19904835 A1 & WO 2000/47686 A1<br>& AU 200031511 A & BR 200008038 A<br>& EP 1161507 A1 & CZ 200102877 A3<br>& ZA 200106456 A & MX 2001007993 A1 | 1-5,8,9<br>6,7 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 10 May, 2011 (10.05.11) | 24 May, 2011 (24.05.11) |
| Name and mailing address of the ISA/<br>Japanese Patent Office<br><br>Facsimile No. | Authorized officer<br><br>Telephone No. |

Form PCT/ISA/210 (second sheet) (July 2009)

**INTERNATIONAL SEARCH REPORT**

International application No.
PCT/JP2011/056460

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | JP 2002-129113 A (JSR Corp.),<br>09 May 2002 (09.05.2002),<br>claims; examples<br>& KR 2004-030398 A & TW 574339 A | 1,4,5,8,9<br>6,7 |
| X<br>Y | JP 2003-327922 A (JSR Corp.),<br>19 November 2003 (19.11.2003),<br>claims; paragraph [0025]<br>(Family: none) | 1,4,5,8,9<br>6,7 |
| X<br>Y | JP 2006-096860 A (Pioneer Corp.),<br>13 April 2006 (13.04.2006),<br>claims; examples<br>(Family: none) | 1-4,8,9<br>5-7 |
| X<br>Y | JP 2008-231235 A (Toray Industries, Inc.),<br>02 October 2008 (02.10.2008),<br>claims; examples<br>(Family: none) | 1-4,8,9<br>5-7 |
| Y | JP 11-322900 A (Nippon Soda Co., Ltd.),<br>26 November 1999 (26.11.1999),<br>paragraph [0013]<br>(Family: none) | 5,6,7 |
| A | JP 2010-009052 A (Asahi Kasei E-materials Corp.),<br>14 January 2010 (14.01.2010),<br>paragraph [0034]<br>(Family: none) | 1-9 |
| A | JP 2008-159998 A (Nitta Corp.),<br>10 July 2008 (10.07.2008),<br>paragraph [0022]<br>(Family: none) | 1-11 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 5032946 A
- JP H0532946 A
- JP HEI11166164 B
- JP H11166164 A
- JP 2003231872 A


### Non-patent literature cited in the description


- *Secchaku no gijutsu,* 2008, vol. 28 (1